**Europäisches Patentamt**

**European Patent Office**

**Office européen des brevets**

(11) Publication number : **0 457 434 B1**

# EUROPEAN PATENT SPECIFICATION

(45) Date of publication of patent specification :
**29.11.95 Bulletin 95/48**

(51) Int. Cl.$^6$ : **H01L 29/772**

(21) Application number : **91303246.2**

(22) Date of filing : **11.04.91**

(54) **MOS thin film transistor having a drain offset region.**

(30) Priority : **27.04.90 JP 113833/90**

(43) Date of publication of application :
**21.11.91 Bulletin 91/47**

(45) Publication of the grant of the patent :
**29.11.95 Bulletin 95/48**

(84) Designated Contracting States :
**DE FR GB**

(56) References cited :
**EP-A- 0 038 133**
**US-A- 4 232 327**
**US-A- 4 751 196**
**JAPANESE JOURNAL OF APPLIED PHYSICS, EXTENDED ABSTRACTS, 22nd CONF. SOLID STATE DEVICES AND MATERIALS (1990), Tokyo, JP, pp. 1195-1196; T. UEDA et al.: "A 5nm Thick Ultra-Thin Double-Gated Poly Si TFT Using SI2H6 as a Source Gas"**

(56) References cited :
**PATENT ABSTRACTS OF JAPAN, vol. 12, no. 489 (E-696) 21 December 1988 ; & JP-A-63 204 769**
**PATENT ABSTRACTS OF JAPAN vol. 9, no. 225 (E-342) 11 September 1985 ; & JP-A-60 081 869**
**IEEE ELECTRON DEVICE LETTERS, vol. 9, no. 7, July 1988, New York, US, pp. 347-349; TIAO-YUAN HUANG et al.: "A New ImplantThrough-Contact Method for Fabricating High-Voltage TFT's"**

(73) Proprietor : **SHARP KABUSHIKI KAISHA**
**22-22 Nagaike-cho**
**Abeno-ku**
**Osaka (JP)**

(72) Inventor : **Adan, Alberto Oscar**
**2613-1, Ichinomoto-cho**
**Tenri-shi, Nara-ken (JP)**

(74) Representative : **Brown, Kenneth Richard et al**
**R.G.C. Jenkins & Co.**
**26 Caxton Street**
**London SW1H 0RJ (GB)**

## Description

BACKGROUND OF THE INVENTION

1. Field of the Invention

This invention relates to a method of manufacturing a metal oxide semiconductor thin film transistor (MOS thin film transistor), and more particularly to a method of manufacturing a MOS thin film transistor comprising a polysilicon layer and a SOI structure. The thin film transistor manufactured according to present invention is useful particularly as a load device for Static Random Access Memory (SRAM).

2. Description of the Related Art

MOS thin film transistors (called hereunder MOS-TFT) are widely used in large size LSI for LCD (Liquid Crystal Displays) and, as load devices, in Static Random Access Memories (SRAMs). These devices are mainly composed of a polysilicon thin film formed by deposition and therefore have defects of very high density in the film. As a result, leakage current through P-N junction observed in the film is much larger than that obtained in single crystals.

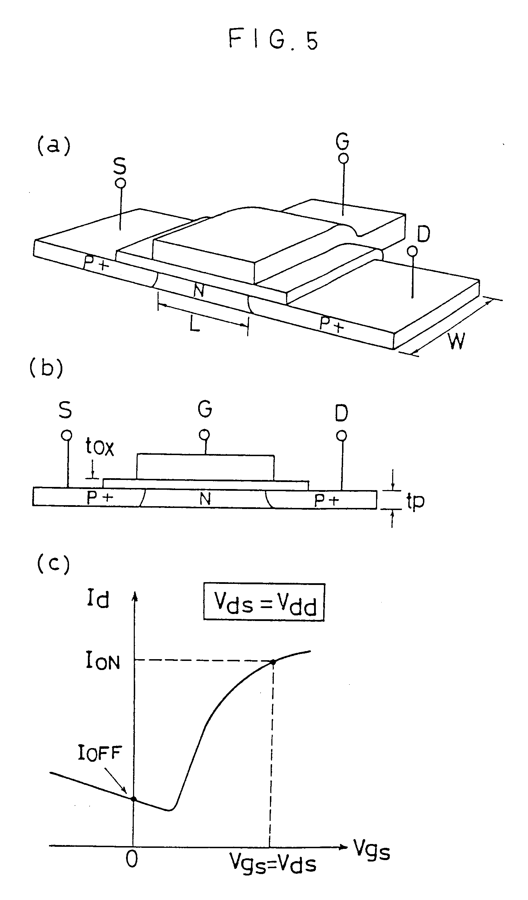

A typical structure of polysilicon MOS-TFT and drain current-gate voltage characteristic (Id-Vgs) thereof are shown in Figs. 5(a) - (c), wherein S is a source, G is a gate, and D is a drain. Off current (I Off) is defined by the drain current observed at a zero gate voltage (Vgs = 0) with a nominal drain-source voltage (Vds = Vdd), and On current (I ON) is defined by the drain current (Id) observed at a nominal gate and drain-source voltage (Vgd = Vds = Vdd).

The OFF current, i.e., leakage current, depends in a complicated way on the recombination-generation mechanism in the drain depletion region. In addition, in polysilicon, or semiconductor films with high level of crystalline defects, this mechanism is enhanced in the depletion region by the drain-gate electric field. The dependence of the OFF current can be represented by the following equation.

$$I_{OFF} = qkT\pi\sigma v_{th}n_i(N_{TS}/S_g)Wt_p(\varepsilon_S Eo/qNd)exp(Em/Eo)^\nu \quad [I]$$

where:

q: Electronic charge  σ: Effective capture cross section
k: Boltzman constant  $V_{th}$: Thermal velocity
T: Absolute Temperature  $n_i$: Semiconductor intrinsic carrier concentration
$N_{TS}$: Traps density (eV/cm²)  $S_g$: Polysilicon grain size
W: Transistor channel width  $t_p$: Polysilicon thickness
$\varepsilon_s$: Dielectric Constant  Eo: Constant ($1\times10^5$ V/cm)
Nd: Donor concentration  Em: Depletion layer maximum electric field
$\nu$ : exponent factor (~1/2)

The above maximum electric field (Em) can be expressed by

$$Em = E_1 + E_2$$
$$E_1 = \sqrt{2qN_{eff}Vd/\varepsilon_{S1}}$$
$$E_2 = \alpha[(Cox/\varepsilon_S)(Vgs - Vds - V_{FB})]$$

wherein $\alpha$ is a fringing field factor (~ 0.5), and $C_{ox}$ is the transistor gate oxide capacitance per unit area. The effect of the electric field Em is given by the exponential enhancement factor: $Fe = exp (Em/Eo)^\nu$, and this exponential dependence with the gate and drain voltages strongly increases the OFF current of the device.

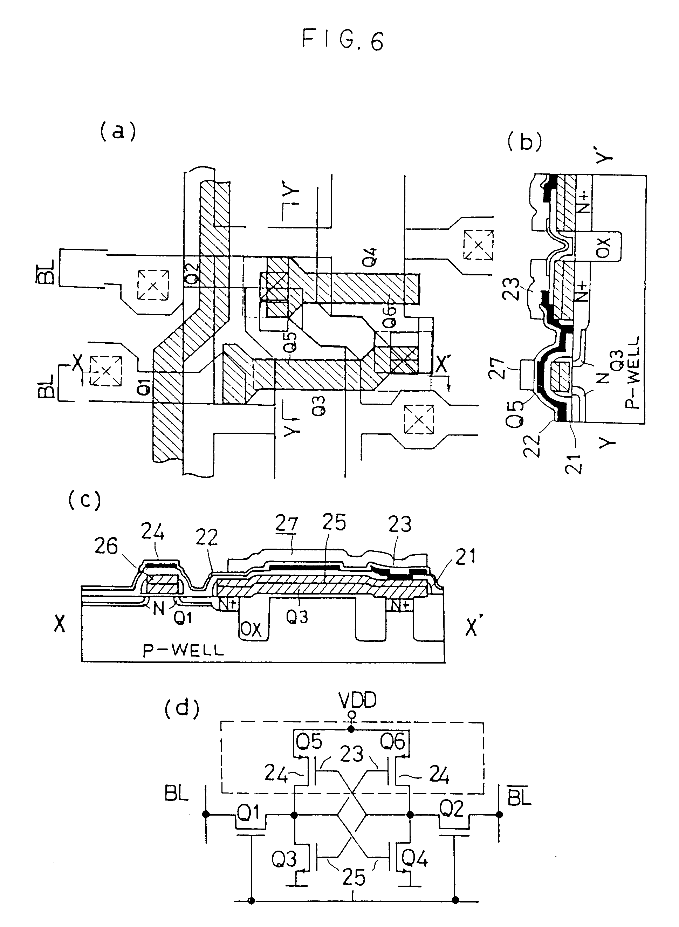

For applications requiring Static Random Access Memory (SRAMs) to operate with battery, it is essential to have a very low standby power dissipation. For this purpose, such a polysilicon PMOS TFT has been proposed as the load device in the SRAM cell as shown in Figs. 6(a) - (d) being a plan view, a sectional view taken from the line Y - Y', a sectional view taken from the line X - X', and a diagram of the equivalent circuit, respectively. In the Figures, reference numeral 21 shows a first intermediate oxide film, 22 a second intermediate oxide film, 23 a third polysilicon layer, 24 a second polysilicon layer, 25 a first polysilicon layer, 26 a WSi_x layer, and 27 a P-MOS FET, and Q1 to Q6 specific portions constituting the device.

However, for high density memory, with more than 1 Megabit capacity, a 1 µA total standby current should be specified. This requires that the OFF current of the polysilicon PMOS TFT to be less than 0.1pA. To meet this requirement and in accordance with the equation [I], various attempts have been made for improving the quality of the polysilicon film by using such a growing technique as enabling a film formation with a larger grain size (Sg~1µm). In this respect, a very thin polysilicon film (tp~10nm) has been formed and proposed to use for the device. However, such a film is very difficult to be produced with good reproductivity in mass production.

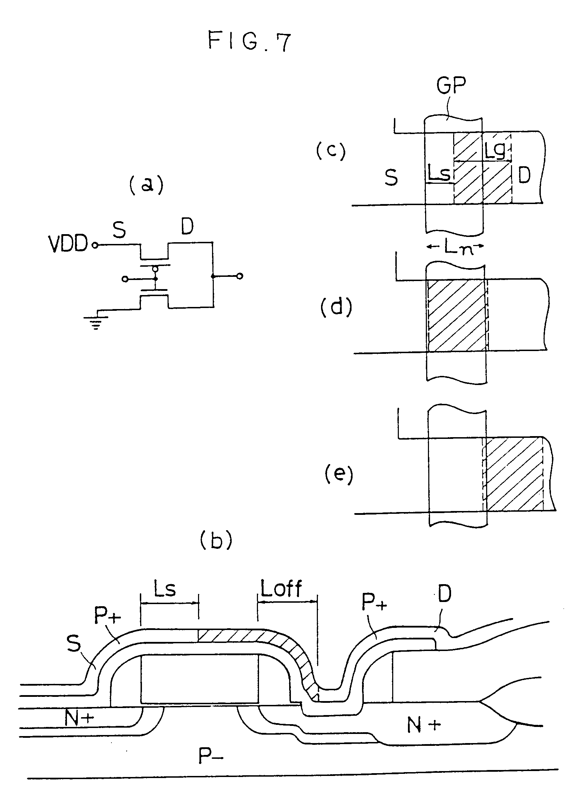

Another proposal to reduce the OFF current is to apply the drain-offset structure as shown in Figs.7 (a) and (b). In this case, the TFT channel region must be defined directly by the pattern of a photoresist mask, because the gate electrode is under the TFT channel, or the device body. The problem with this technique is the difficulty to align the channel with the underlying gate electrode, specially in submicron size devices as required in high density SRAM. As illustrated in Fig. 7(c), supposing the bulk NMOS transistor of being minimum channel length (Ln), the alignment tolerance is approximately DM = Ln/2. That is, the channel length of the polysilicon PMOS transistor, under the gate (GP), will vary between 0 and Ln (See Figs. 7(d) and (e)).

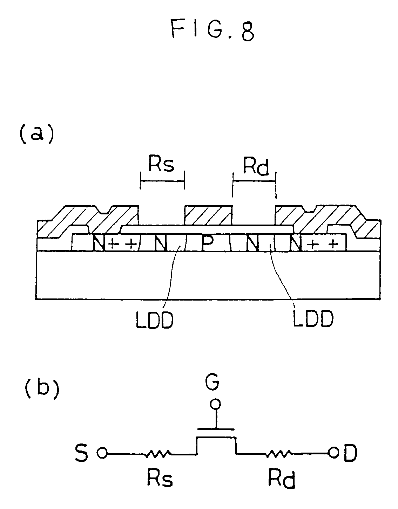

Also, an LDD (Lightly Doped Drain) structure with source and drain-offset ($R_s$ and $R_d$ as shown in Figs. 8 (a) and (b) is proposed to reduce OFF current and improve the ON/OFF ratio. Structures using this principle are described in US-A-475196 and in Patent Abstract of Japan, vol. 12, no. 489 (referring to JP-A-63204769). Such a structure is symmetric, in the sense that both the source and drain are lightly doped regions. However, this creates a series resistance with the source electrode which reduces the transistor drain ON current.

Reference is also made to EP-A-0038133 which relates to a method of manufacturing semiconductor devices with said micron lines. A short channel insulated gate field effect transistor is described as being manufactured by a self-aligned process in which the gate electrode is formed by a selected action technique. In practising the process, an etch limiting element is laterally diffused from an edge of an adjacent solid source, eg a doped oxide layer, into a polycrystalline silicon layer in contact with that edge forming a doped region which is left behind as the gate electrode after subsequent etching steps which remove the undoped poly-silicon, the source layer and other oxide layers. A portion of the solid source may serve as a mask in another step of the process to define the length of a drain extension region.

Reference is also made to US-A-4232327 which relates to an extended drain self-aligned silicon gate MOSFET and is the closest prior art according to the preamble of claim 1. In that document, a body of semiconductor material is provided with source, drain and channel regions. A gate structure is provided over the interstitial channel region of the semiconductor body between the drain and source regions, one edge of which is aligned with the source region. The remainder of the channel region between the other edge of the gate structure and the adjacent edge of the drain region is provided with a drift region of a conductivity type that is opposite to that of the source and drain.

Reference is also made to Patent Abstracts of Japan, Vol. 9, No. 225 (relating to JP-A-60081869) which describes a driving method for a thin film transistor. A thin film transistor has an insulating transparent substrate, a substrate insulating film, a lower gate insulating film, a lower gate electrode, a thin semiconductor film, a source region, a drain region, an upper gate insulating film, an upper gate electrode, an interlayer insulating film, a source electrode, and a drain electrode. In order to decrease the OFF current, when the transistor is OFF, the voltage near the flat band voltage of the lower boundary is applied to the lower gate electrode, while to increase the ON current, when the transistor is ON, a voltage higher than a threshold voltage is applied to the lower gate electrode.

## SUMMARY OF THE INVENTION

The present invention provides a method of making a thin film transistor having a self-aligned asymmetrical structure, said method comprising:

forming a semiconductor thin film over a substrate, said thin film being formed to include a drain region, a channel region and a partial source region, said drain and partial source regions being of one conductivity type and said channel region being of another conductivity type;

forming a gate electrode over said channel region and a pair of electrodes including a drain electrode and a source electrode;

completing the formation of the source region in a self-aligned manner by ion implantation using said gate electrode as a mask; characterised in that: said drain electrode is concurrently formed with said gate electrode by the same layer forming said gate electrode, whereby a drain-offset region is formed between said gate electrode and drain electrode; and

the ion implantation to complete the source is performed using said source electrode and said gate electrode as a mask.

The invention enables a MOS thin film transistor to be produced without requiring a very thin film, which would be difficult to produce. Such a transistor comprises TFT structure having a self-aligned structure, an asymmetrical drain-offset structure, and having a low OFF current.

According to the asymmetrical drain-offset structure of this invention, the maximum drain-gate electric field is decreased due to the offset between the gate electrode and the drain region, and therefore leakage due to field enhanced generation-recombination at the drain PB junction is reduced and the OFF current is correspondingly reduced. Also, the self-aligned source region ensures the direct application of the gate voltage to the channel region without causing ON current reduction by the parasitic source resistance, and the self-aligned drain-offset region precisely defines the distance between the gate and the drain electrodes which results in simplifying the steps in the fabrication of the TFT device.

## BRIEF DESCRIPTION OF THE DRAWINGS

Figs. 1 to 3 are sectional views each showing a structure of an example of the thin film transistor manufactured according to the present invention.

Figs. 4(a)-(h) are sectional views sequentially showing a fabrication process of the thin film transistor according to the present invention.

Figs. 5(a) and (b) are sectional views each showing a basic structure of a conventional MOS-TFT and Fig. 5(c) is a graph showing a drain current-gate voltage characteristic (Id-Vgs) thereof.

Figs. 6 to 8 are sectional views each concretely showing a construction of the conventional MOS-TFT.

## DETAILED DESCRIPTION OF THE PREFERRED EMBODIMENTS

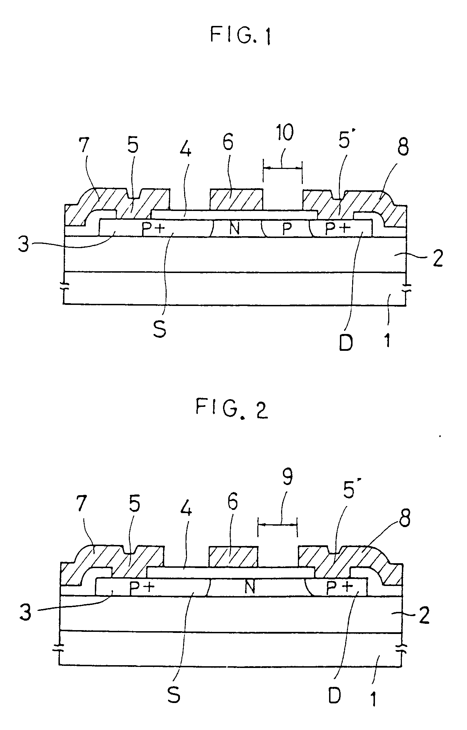

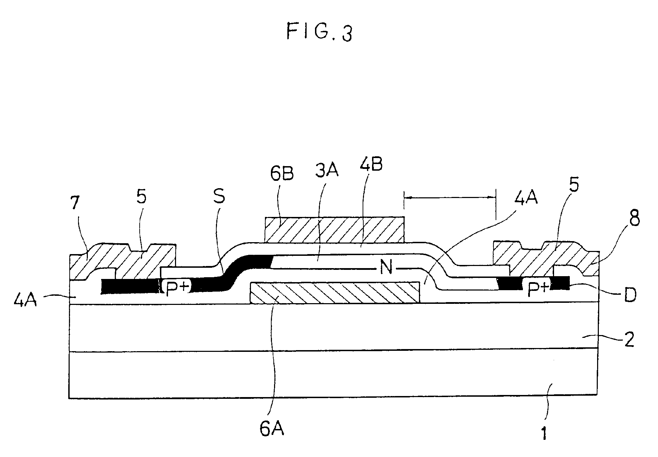

Typical MOS thin film transistors of single gate type with self-aligned asymmetrical drain-offset structure manufactured according to the present invention are illustrated in Figs. 1 and 2. The thin film transistor may be a double gate TFT as shown in Fig. 3.

The thin film transistor manufactured according to the present invention may be NMOS or PMOS type. Hereinafter, a PMOS type TFT as shown in Fig. 2 is typically illustrated.

As shown, the PMOS-TFT comprises a substrate 1 made of a semiconductor or an insulating material such as quartz, on which an insulating layer 2 (made, for example, of $SiO_2$, SiN and the like) is formed by CVD process or thermal growth. A semiconductor thin film transistor body 3 (for example, a polysilicon layer) is deposited on the insulating layer 2 and a MOS gate oxide layer 4 is also deposited by CVD process or thermal growth. Contact holes 5 and 5′ are made in the gate oxide layer 4 by etching, and the film (3) is heavily doped P-type through these holes by ion implantation of Boron ions.

A top electrode layer made of either polysilicon or metal is deposited and patterned to form the gate, source and drain electrodes 6, 7 and 8, respectively. By using a photoresist mask, which overlaps the gate and drain electrodes, ion implantation (boron) is performed to form a self-aligned source region S and drain offset region 9 as shown in Fig. 2. By removing the photoresist and performing an additional low concentration boron ion implantation, an asymmetrical LDD offset structure (LDD region 10) is formed as shown in Fig. 1.

Characteristics of the above TFT structure are: (a) the top gate electrode configuration, (b) the offset region of low concentration p-type or n-type semiconductor between the gate and drain, (c) High concentration doping of the drain through the contact hole, and (d) the source-gate self-aligned structure with heavily doped source to reduce parasitic source series resistance.

It is in general suitable that the thickness of the body 3 be about 20 to 60nm and the width be about 0.5 to 1.0μm, the width of the gate electrode be about 0.6 to 2μm, and the width of the drain-offset region be about 0.5 to 1μm.

Further, in the Figs 1 and 2, the concentrations of impurity are suitably about $10^{14}$ to $10^{15}$ /cm$^2$ for the P$^+$-type source and drain regions, about $10^{12}$ to $10^{13}$/cm$^2$ for the N-type channel region and the N-type drain-offset region, and about $10^{12}$ to $10^{13}$/cm$^2$ for the P-type drain-offset region.

## EXAMPLES

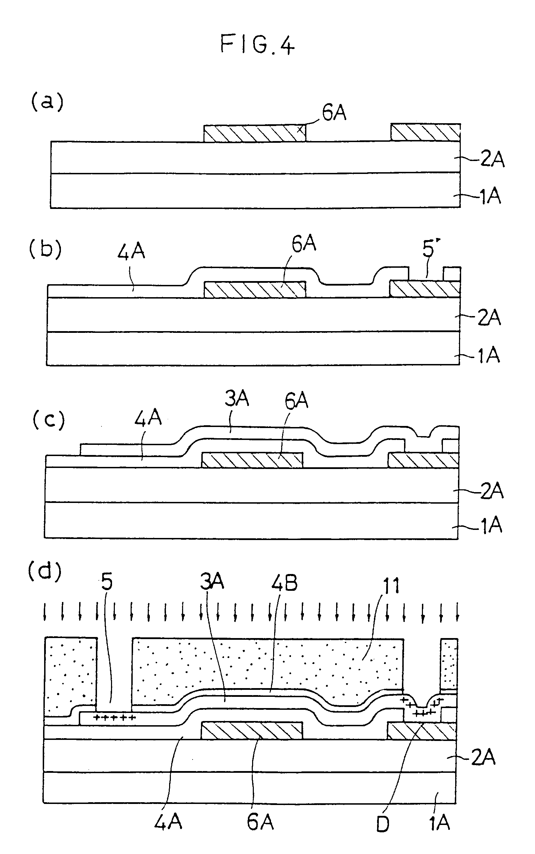

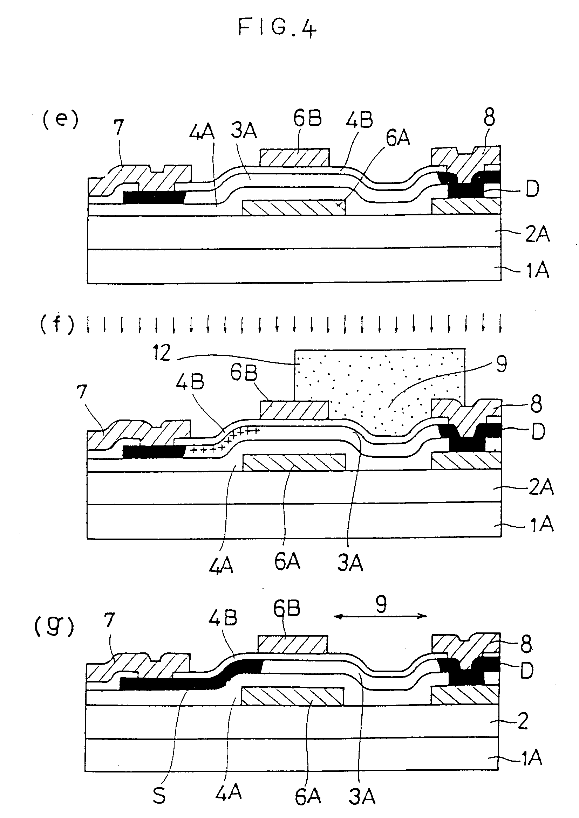

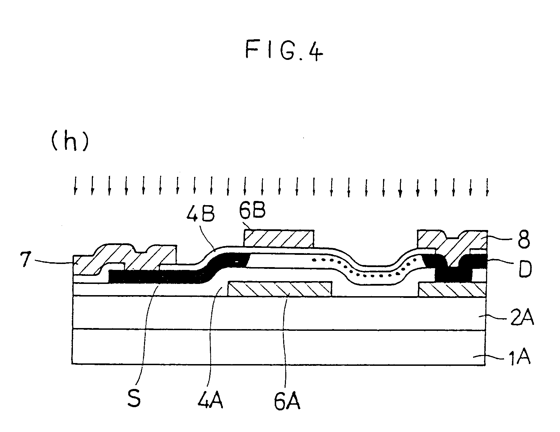

Next, the manufacturing of the self-aligned asymmetrical drain-offset MOS TFT according to the present invention is detailed with referring a fabrication process of a double gate TFT as shown in Figs. 4(a) to (g).

First, as shown in Fig. 4(a), on a silicon substrate 1A, an insulating silicon oxide layer 2A (about 0.5 μm in thickness) is grown or deposited by CVD process and a bottom gate electrode 6A (polysilicon, about 0.3 μm in thickness) is deposited by LPCVD process and patterned by photoetching.

Then, as shown in Fig. 4(b), a silicon oxide layer 4A (about 50 nm in thickness) is thermally grown or deposited by CVD process to form a dielectric for the bottom electrode 6A, and a contact hole 5′ is made by photoetching. Thereafter, a second polysilicon layer 3A (about 50 nm in thickness) is deposited and patterned by photoetching to form a polysilicon transistor body as shown in Fig. 4(c).

Next, an oxide layer 4B (about 30 nm in thickness) is thermally grown or deposited by CVD process to form a dielectric for top gate electrode, and a contact hole 5 is made by photoetching using photoresist mask 11. After this etching, the photoresist mask 11 is used as mask and ion implantation is performed as shown in Fig. 4(d) to dope the transistor drain region D and a part of the source region, typically with about 5 x $10^{15}$cm$^{-2}$ concentration of boron ions. After this implantation, the photoresist 11 is removed.

Alternatively, the ion implantation of the drain region D may be carried out before the formation of the hole 5′ in the oxide layer 4B. In this case, the photoresist mask 11 is delineated, boron ions are implanted through the oxide layer 4B, appropriately inhibiting channeling. After implantation, contact hole 5′, in the oxide layer 4B, are opened.

Then, as shown in Fig. 4(e), a layer of metal or a third polysilicon layer is deposited and patterned by photoetching to form a polysilicon top gate electrode 6B, a source electrode 7 and a drain electrode 8. As shown in Fig. 4(f), a photoresist mask 12 is then formed to cover the drain-gate offset region 9 and a Boron ion implantation with high concentration (~5 x $10^{15}$cm$^{-2}$) is performed to form a self-aligned source region S (Fig. 4(g)). Then, the photoresist mask 12 is removed to complete the formation of the self-aligned asymmetrical drain-offset TFT of the present invention.

In this example, following the photoresist removal, an ion implantation with low concentration impurity is performed as shown in Fig. 4(h) to form a self-aligned asymmetrical ligthly doped drain (ALDD) TFT structure. This concentration is adjusted to optimize the device characteristics to be exhibited, but typically of about ~$10^{13}$cm$^{-2}$ in the case of boron.

Polysilicon TFT is an inexpensive device and widely used in LCD, SRAM, 3-D integrated circuits and the like. However, the high density of defects in the thin film transistor body makes the TFT very leaky as compared with transistors fabricated in a single crystal semiconductor. The leakage current in polysilicon MOS TFT is due to the electric field enhanced generation-recombination at the drain P-N junction induced by the high electric field which is capacitively coupled with the gate electrode. According to the self-aligned asymmetrical LDD or self-aligned asymmetrical drain offset TFT structure manufactured according to the present invention, the enhanced generation-recombination of electric field is remarkably suppressed which results in decreased OFF current.

That is, in the structures manufactured according to the present invention, the drain region and the channel region are isolated by the drain-offset region, so as to reduce the electric field intensity thereby decreasing the OFF current.

Also, the top gate electrode allows the source region to be defined in self-aligned manner thereby eliminating the source parasitic series resistances which reduce the ON (drive) current of the TFT.

Furthermore, the drain offset region is easily and precisely defined in self-aligned manner by the use of a photoresist mask which overlaps the previously formed gate and drain electrodes.

In summary, using the TFT structures manufactured according to the present invention allows a high performance polysilicon MOS TFT with lower OFF current, high ON/OFF ratio and good controllability of its characteristics, to be realized and fabricated with improved yield and reduced cost.

## Claims

1. A method of making a thin film transistor having a self-aligned asymmetrical structure, said method comprising:

    forming a semiconductor thin film (3) over a substrate, said thin film being formed to include a drain region (D), a channel region (3A) and a partial source region, said drain and partial source regions being of one conductivity type and said channel region being of another conductivity type;

    forming a gate electrode (6; 6B) over said channel region and a pair of electrodes including a drain electrode (8) and a source electrode (7);

    completing the formation of the source region in a self-aligned manner by ion implantation using said gate electrode as a mask; characterised in that:

    said drain electrode is concurrently formed with said gate electrode by the same layer forming said gate electrode, whereby a drain-offset region (9) is formed between said gate electrode and drain electrode; and

    the ion implantation to complete the source is performed using said source electrode and said gate electrode as a mask.

2. A method as in claim 1, further comprising:

    forming a second gate (6A) on said substrate prior to forming said semiconductor thin film over said substrate.

3. A method as in claim 1 or 2 in which said semiconductor thin film (3) has a thickness of 20 to 60 nm.

4. A method as in claim 1, 2, 3, wherein an ion is implanted in low concentration in said drain-offset region (9) using said gate electrode (6; 6B) and drain electrode (8) as a mask after completing the formation of the source region.

5. A method as in claim 1, 2, 3, wherein said drain-offset region is formed between said channel region (3A) and said drain region (D) in a self-aligned manner by ion implantation using said gate (6; 6B) and drain electrodes (8) as a mask.

6. A method as in any preceding claim, wherein said source electrode (7) is formed concurrently with the formation of said gate electrode (6; 6B) and drain electrode (8) by the same layer forming said gate electrode and drain electrode.

7. A method as in any preceding claim, wherein said drain-offset region is covered with a mask (12) for the step of completing the formation of the source region.

8. A method as in claim 7, wherein said drain-offset region is of the same conductivity type as said drain region (D).

9. A method as in claim 7, wherein said drain-offset region is of the same conductivity type as said channel region.

## Patentansprüche

1. Verfahren zum Herstellen eines Dünnfilmtransistors mit selbstausgerichteter, asymmetrischer Struktur, umfassend:

    - Herstellen eines Halbleiter-Dünnfilms (3) auf einem Substrat, der so ausgebildet wird, daß er einen Drainbereich (D), einen Kanalbereich (3A) und einen Sourceteilbereich beinhaltet, wobei der Drain- und der Sourceteilbereich von einem Leitungstyp sind und der Kanalbereich vom anderen Leitungstyp ist;

- Herstellen einer Gateelektrode (6; 6B) auf dem Kanalbereich, und eines Paars Elektroden einschließlich einer Drainelektrode (8) und einer Sourceelektrode (7);

- Fertigstellen der Ausbildung des Sourcebereichs auf selbstausgerichtete Weise durch Ionenimplantation unter Verwendung der Gateelektrode als Maske; **dadurch gekennzeichnet, daß**

- die Drainelektrode gleichzeitig mit der Gateelektrode mittels derselben Schicht, die die Gateelektrode bildet, hergestellt wird, wobei zwischen der Gateelektrode und der Drainelektrode ein Drainversatzbereich (9) hergestellt wird; und

- die Ionenimplantation zum Fertigstellen der Source unter Verwendung der Sourceelektrode und der Gateelektrode als Maske ausgeführt wird.

2. Verfahren nach Anspruch 1, ferner umfassend das Herstellen eines zweiten Gates (6A) auf dem Substrat vor dem Herstellen des Halbleiter-Dünnfilms auf dem Substrat.

3. Verfahren nach einem der Ansprüche 1 oder 2, bei dem der Halbleiter-Dünnfilm (3) eine Dicke von 20 bis 60 nm aufweist.

4. Verfahren nach einem der Ansprüche 1, 2 oder 3, bei dem Ionen mit niedriger Konzentration unter Verwendung der Gateelektrode (6; 6B) und der Drainelektrode (8) als Maske in den Drainversatzbereich (9) implantiert werden, nachdem die Herstellung des Sourcebereichs abgeschlossen wurde.

5. Verfahren nach einem der Ansprüche 1, 2 oder 3, bei dem der Drainversatzbereich zwischen dem Kanalbereich (3A) und dem Drainbereich (D) auf selbstausrichtende Weise durch Ionenimplantation unter Verwendung der Gate- (6; 6B) und Drainelektroden (8) als Maske ausgebildet wird.

6. Verfahren nach einem der vorstehenden Ansprüche, bei dem die Sourceelektrode (7) gleichzeitig mit der Herstellung der Gateelektrode (6; 6B) und der Drainelektrode (8) mittels derselben Schicht ausgebildet wird, die die Gateelektrode und die Drainelektrode bildet.

7. Verfahren nach einem der vorstehenden Ansprüche, bei dem der Drainversatzbereich zum Schritt des Fertigstellens der Herstellung des Sourcebereichs durch eine Maske (12) abgedeckt wird.

8. Verfahren nach Anspruch 7, bei dem der Drainversatzbereich vom selben Leitungstyp wie der Drainbereich (D) ist.

9. Verfahren nach Anspruch 7, bei dem der Drainversatzbereich vom selben Leitungstyp wie der Kanalbereich ist.

**Revendications**

1. Procédé de préparation d'un transistor à couche mince présentant une structure asymétrique auto-alignée, ledit procédé comprenant les étapes consistant à :

former une couche mince de semiconducteur (3) sur un substrat, ladite couche mince étant formée de manière à inclure une région de drain (D), une région de canal (3A) et une région de source partielle, lesdites régions de drain et de source partielle étant d'un type de conductivité et ladite région de canal étant d'un autre type de conductivité,

former une électrode de grille (6, 6B) sur ladite région de canal et deux électrodes comprenant une électrode de drain (8) et une électrode de source (7),

terminer la formation de la région de source avec auto-alignement par implantation d'ions en utilisant ladite électrode de grille comme masque; caractérisé en ce que :

ladite électrode de drain est formée simultanément avec ladite électrode de grille par la même couche formant ladite électrode de grille, en sorte qu'une région de décalage de drain (9) soit formée entre ladite électrode de grille et ladite électrode de drain, et

l'implantation d'ions pour compléter la source est réalisée en utilisant ladite électrode de source et ladite électrode de grille comme masque.

2. Procédé selon la revendication 1, comprenant en outre l'étape consistant à former une deuxième grille (6A) sur ledit substrat avant la formation de ladite couche mince de semiconducteur sur ledit substrat.

3. Procédé selon la revendication 1 ou 2, dans lequel ladite couche mince de semiconducteur (3) a une épaisseur de 20 à 60 mn.

4. Procédé selon la revendication 1, 2 ou 3, dans lequel un ion est implanté en faible concentration dans ladite région de décalage de drain (9) en utilisant ladite électrode de grille (6; 6B) et l'électrode de drain (8) comme masque après avoir terminé la formation de la région de source.

5. Procédé selon la revendication 1, 2 ou 3, dans lequel ladite région de décalage de drain est formée entre ladite région de canal (3A) et ladite région de drain (D) de manière auto-alignée par implantation d'ions en utilisant lesdites électrodes de grille (6; 6B) et de drain (6) comme masque.

6. Procédé selon l'une quelconque des revendications précédentes, dans lequel ladite électrode de source (7) est formée en même temps qu'est formée ladite électrode de grille (6; 6B) et l'électrode de drain (8) par la même couche formant ladite électrode de grille et ladite électrode de drain.

7. Procédé selon l'une quelconque des revendications précédentes, dans lequel ladite région de décalage de drain est revêtue d'un masque (12) dans l'étape d'achèvement de la formation de la région de source.

8. Procédé selon la revendication 7, dans lequel ladite région de décalage de drain est de même type de conductivité que ladite région de drain (D).

9. Procédé selon la revendication 7, dans lequel ladite région de décalage de drain est du même type de conductivité que ladite région de canal.

EP 0 457 434 B1

FIG. 1

FIG. 2

FIG. 3

# FIG.4

(a)

(b)

(c)

(d)

FIG.4

(e)

(f)

(g)

# FIG.4

(h)

# FIG. 5

(a)

(b)

(c)

FIG. 6

(a)

(b)

(c)

(d)

# FIG. 7

(a)

VDD—S D

(b)

(c)

GP

S D

Ls Lg

(d)

←Ln→

(e)

Ls Loff

P+ P+ D

S

N+ N+

P−

# FIG. 8

(a)

(b)